# EUROPEAN PATENT APPLICATION

(11) **EP 1 170 783 A1**
(43) Date of publication of application: **09.01.2002**
(21) Application number: 01810573.4
(22) Date of filing: 14.06.2001
(51) Int. Cl.: H01L 21/00

(54) **Pick-up-tool**

(30) Priority: 03.07.2000 EP 00810578
(71) Applicant: Esec Trading S.A., 6330 Cham (CH)
(72) Inventor: Ulrich, René Josef, 6353 Weggis (CH)
(74) Representative: Falk, Urs, Dr.

(57) **Abstract**

A pick-up tool for the mounting of semiconductor chips onto a substrate has a suction device which consists of a plate (4) made out of a dimensionally stable material one surface of which (5) has structures (6) made of hardened adhesive. The material for the plate (4) is, for example, aluminium, a carbon fibre composite material or a dimensionally stable plastic. A suitable material for the structures (6) is, for example, an adhesive which has Teflon® as the filling material.

## Description

The invention concerns a pick-up tool for the mounting of semiconductor chips onto a substrate. Such pick-up tools are known under the technical terms "die collet" or "die bonding tool".

With the mounting of semiconductor chips, the semiconductor chips sawn out of a wafer and stuck to a foil are grasped by a pick-up tool and placed onto a substrate. Such a pick-up tool basically consists of a metal shaft and a suction device secured to it which has a cavity directed towards the component to be grasped to which vacuum can be applied via a drill hole. As soon as the suction device rests on the component, the vacuum effects the adhesion of the component to the suction device.

The attachment of the semiconductor chips to the substrate takes place with differing adhesive materials depending on the area of application. Apart from soft solder, with which the semiconductor chip is soldered to the substrate, and adhesive tape, mainly electrically conducting, silver incorporating as well as non-conducting liquid adhesives with an epoxy base are used. Recently however, adhesives have become known which are based on new molecular systems which harden in relatively shorter times. On the one hand, the adhesive layer must guarantee the adhesion of the semiconductor chip to the substrate, on the other hand it must be capable of compensating the shearing stresses which are caused for example by temperature fluctuations. Because the characteristics of the named adhesives are greatly dependent on the layer thickness, a constant adhesive layer thickness within tight limits is required in order to be able to produce reliable products with identical characteristics.

Also, in order to avoid the slightest damage to the semiconductor chips during mounting, pick-up tools are used whose suction device consists of rubber. Rubber has the additional advantage that it effectively seals the hollow chamber so that the semiconductor chip can be detached from the foil with a relatively large suction force.

These rubber tools however have the serious disadvantage that they cannot be manufactured with sufficient precision. The rubber tools are generally 2 to 3 mm thick. Expensive injection tools are necessary for manufacture. Nevertheless, the finished rubber tools have thickness deviations of 50µm and more. As a result, problems occur especially with the mounting of relatively large semiconductor chips, ie, semiconductor chips with an edge length of 20 mm and more because the adhesive is badly distributed underneath the semiconductor chip, contains air bubbles, does not flow everywhere as far as the edges of the semiconductor chips, has irregular thickness, etc.

The object of the invention is to develop a pick-up tool which enables the perfect mounting of large semiconductor chips.

The named object is solved in accordance with the invention by means of the features of claim 1.

Solving of the task is achieved in accordance with the invention in that the pick-up tool has a suction plate made out of dimensionally stable material the surface of which facing towards the semiconductor chip has structures made of a curable adhesive. An adhesive proven and accepted in the semiconductor industry serves as the adhesive. The suction plate guarantees the rigidity or dimensional stability of the pick-up tool. The structures made of cured adhesive guarantee the necessary elasticity so that the semiconductor chip is not scratched and so that the cavity formed between the pick-up tool and the semiconductor chip is vacuum sealed.

In the following, an embodiment of the invention is explained in more detail based on the drawing.

It is shown in:

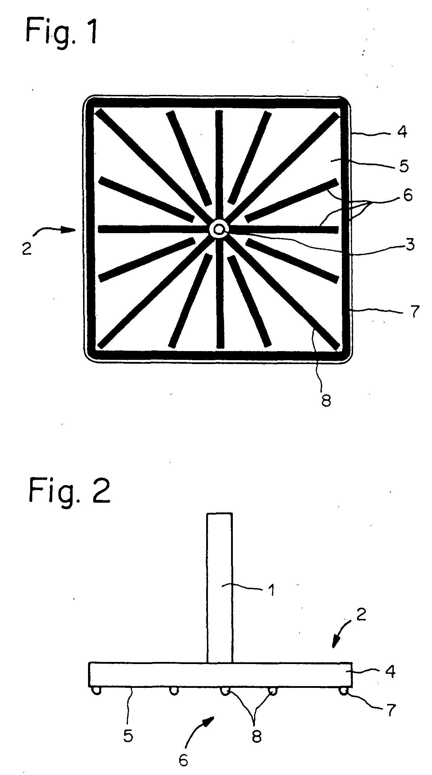

- Figs. 1 and 2: a pick-up tool.

Figs. 1 and 2 show a plan view and a cross-section of a pick-up tool which comprises a shaft I and a suction plate 2 made of dimensionally stable material as the actual suction device. The shaft 1 is formed so that the suction plate 2 is held stable and at right angles to the longitudinal axis of the shaft 1. Preferably, the suction plate 2 is not just pushed onto the shaft I but in addition is fixed with a fast setting thermal adhesive. The suction plate 2 has a drill hole 3 in the centre which, via the shaft 1, can be connected to a vacuum source.

The suction plate 2 consists of an approximately two millimetre thick dimensionally stable plate 4 one surface 5 of which has structures 6 made out of a material proven in the semiconductor industry. Preferably, anodized aluminium serves as the material for the plate 4. Compared with non-anodized aluminium, anodized aluminium offers the advantage of corrosion resistance. The plate 4 can however also be manufactured from a carbon fibre composite material or a dimensionally stable plastic. A plate 4 made of plastic can be economically manufactured for example with the injection moulding process. Carbon fibre composite materials as well as plastics demonstrate the advantage of low weight at sufficient or even greater dimensional stability as compared with metals. A fast setting adhesive serves as the material for the structures 6 which preferably contains a large portion of Teflon® as filling material. Such a material is available for example from the company Dexter under the designation QMI536. The material QMI536 is an electrical isolator and has a modulus of elasticity of 300 MPa. The structures 6 are therefore sufficiently elastic so that they do not scratch the semiconductor chip. It is also possible to use an electrically conducting adhesive for the structures 6 which, in operation, is connected to ground either directly or via the, in this case preferably, non-anodized plate 4. A suitable material is available from Dexter under the designation QMI506. It contains silver as the filling material and has a modulus of elasticity of 630 MPa.

The aluminium plate 4 can be implemented in various colours. The anodized aluminium plate 4 offers an optimum surface for the structures 6. The structures 6 comprise a closed border line 7 as well as supporting lines 8 radiating out from the centre of the aluminium plate 4. The height of the structures 6 amounts typically to around 0.2 mm. In order to achieve a high uniformity in the height of the structures 6, the adhesive is first applied with a writing head at a thickness of around 0.25 mm, hardened and then ground by around 0.05 mm parallel to the surface of the aluminium plate 4.

The border line 7 of the structures 6 has the task of sealing the vacuum zone formed by the aluminium plate 4, the border line 7 and the picked up semiconductor chip. The supporting lines 8 have the task of supporting the semiconductor chip and preventing the semiconductor chip from bending when placing it onto the substrate. Furthermore, the structures 6 must be made of a material which, on the one hand, excludes any damage to the semiconductor chip and, on the other hand, under no circumstances leaves residue on the chip surface.

The pick-up tool in accordance with the invention has the following advantages:
- The rigidity or dimensional stability of the pick-up tool is significantly higher than a customary pick-up tool with a suction device made of rubber. The supporting lines 8 prevent the semiconductor chip from bending when placing it onto the substrate. The adhesive therefore spreads evenly underneath the semiconductor chip and an adhesive layer of constant thickness is formed which is free of air bubbles.
- The structures 6 themselves do not adhere to the semiconductor chip. After switching off the vacuum, the semiconductor chip remains positionally accurate lying on the portion of adhesive applied to the substrate.
- The low height of the structures 6 has the result that the volume of the hollow chamber between the semiconductor chip and the aluminium plate 4 is very small so that the force build-up on creating the vacuum and the force reduction on releasing the vacuum take place very quickly.
- Slim and very light pick-up tools result even for the largest chip dimensions.

As long as the vacuum holding force is large enough, it is of advantage to size the dimensions of the pick-up tool smaller, typically around 70%, than the dimensions of the semiconductor chip. In this way, it can be achieved that the edge of the semiconductor chip, as seen from the centre of the suction device, always deflects upwards. The result is a perfect spreading of the adhesive as far as the edges of the semiconductor chip as well as the subsequent development of the fillet with sufficient adhesive and without air bubbles.

The pick-up tool is also suitable for small semiconductor chips. However the supporting lines 8 can then be omitted.

## Claims

1. Pick-up tool with a suction device for the mounting of semiconductor chips onto a substrate, **characterised in that** the suction device is a plate (4) made from a dimensionally stable material one surface of which (5) has structures (6) of a cured adhesive.

2. Pick-up tool according to claim 1, **characterised in that** the plate (4) is made of aluminium.

3. Pick-up tool according to claim 1, **characterised in that** the plate (4) is made of aluminium, one surface of which (5) is anodized.

4. Pick-up tool according to claim 1, **characterised in that** the plate (4) consists of carbon fibre composite material.

5. Pick-up tool according to claim 1, **characterised in that** the plate (4) consists of plastic.

6. Pick-up tool according to one of the previous claims 1 to 5 **characterised in that** the structures (6) comprise a border line (7) and supporting lines (8).
